# EUROPÄISCHE PATENTSCHRIFT

(11) **EP 2 321 863 B1**
(45) Veröffentlichungstag und Bekanntmachung des Hinweises auf die Patenterteilung: **10.10.2018**
(21) Anmeldenummer: 09776086.2
(22) Anmeldetag: 10.08.2009
(51) Int. Cl.: H01L 51/52, H01L 51/44, H01L 21/316

(54) **VERFAHREN ZUR HERSTELLUNG EINES ORGANISCHEN STRAHLUNGSEMITTIERENDEN BAUELEMENTS UND ORGANISCHES STRAHLUNGSEMITTIERENDES BAUELEMENT**
METHOD FOR PRODUCING AN ORGANIC RADIATION-EMITTING COMPONENT AND ORGANIC RADIATION-EMITTING COMPONENT
PROCEDE POUR PRODUIRE UN PHOTOEMETTEUR ORGANIQUE, ET PHOTOEMETTEUR ORGANIQUE

(30) Priorität: 04.09.2008 DE 102008045948
(43) Veröffentlichungstag der Anmeldung: 18.05.2011
(73) Patentinhaber: OSRAM OLED GmbH, 93049 Regensburg (DE)
(72) Erfinder: GÄRDITZ, Christoph, 93051 Regensburg (DE); PÄTZOLD, Ralph, 91154 Roth (DE)
(74) Vertreter: Epping - Hermann - Fischer
(86) Internationale Anmeldenummer: PCT/DE2009/001139
(87) Internationale Veröffentlichungsnummer: WO 2010/025696

(56) Entgegenhaltungen:
- EP-A1- 1 887 628
- EP-A2- 1 480 280
- WO-A1-2005/106573
- WO-A1-2007/029756
- US-A1- 2006 017 375

## Beschreibung

Diese Patentanmeldung beansprucht die Priorität der deutschen Patentanmeldung 10 2008 045 948.8.

Es werden ein Verfahren zur Herstellung eines organischen strahlungsemittierenden Bauelements und ein organisches strahlungsemittierendes Bauelement angegeben.
Eine wünschenswerte Eigenschaft von großflächigen organischen Leuchtdioden (OLEDs) für Beleuchtungszwecke ist die Homogenität der Leuchtdichte über die aktive, lichtemittierende Fläche. Eine herkömmliche OLED weist üblicherweise zwei Elektrodenschichten auf, zwischen denen organische Schichten zur Erzeugung und Emission von Licht angeordnet sind. Die Elektrodenschichten der OLED weisen aufgrund der üblicherweise verwendeten geringen Schichtdicken und/oder Materialien einen relativ hohen elektrischen Widerstand auf. Aufgrund dieses hohen elektrischen Widerstandes, der eine relativ geringen Querleitfähigkeit entlang der Erstreckungsrichtung oder -ebene der Elektrodenschichten bedingt, entsteht bei hohen Stromdichten ein Spannungsabfall entlang der Erstreckungsrichtung oder - ebene, der zu einer erheblichen Inhomogenität der Leuchtdichte führen kann. Speziell bei Beleuchtungsanwendungen, die eine große und homogene Leuchtfläche erfordern, ist dies aber unerwünscht.

Die Druckschrift WO 2007/029756 A1 beschreibt eine transparente leitfähige Schicht mit einer Hilfsverdrahtung, die ein strukturiertes Grundmaterial umfasst, das eine leitfähige Schicht beispielsweise aus Aluminium mit einer Oberfläche aus einer Aluminiumoxidschicht aufweist.

Die Druckschrift EP 1 887 628 A1 beschreibt eine elektrooptische Vorrichtung, die eine Trägerschicht, eine darauf angeordnete erste Elektrodenschicht, eine überstehende Struktur mit einer leitfähigen Struktur und einer nichtleitfähigen Struktur und eine zweite Elektrodenschicht aufweist, wobei sich die überstehende Struktur von der ersten zur zweiten Elektrodenschicht erstreckt und elektrooptische Schichten zwischen der überstehenden Struktur und den Elektrodenschichten angeordnet sind. Die leitfähige Struktur ist aus Aluminium und die nicht-leitfähige Struktur ist aus Aluminiumoxid.

Die Druckschrift WO 2005/106573 A1 beschreibt ein organisches elektrolumineszierendes Bauelement mit einer Anode auf einem Substrat und darüber einer strukturierten Hilfselektrode, die durch einen isolierenden Film bedeckt wird. Darüber sind eine organische elektrolumineszierende Schicht und eine Kathode angeordnet.

Die Druckschrift EP 1 480 280 A2 beschreibt ein Verfahren zur Herstellung eines organischen elektrolumineszierenden Bauelements, bei dem auf eine transparente Elektrodenschicht eine streifenförmig strukturierte Schicht aufgebracht und mittels Plasmabehandlung oxidiert wird.

Eine Aufgabe von zumindest einer Ausführungsform ist es, ein Verfahren zur Herstellung eines organischen strahlungsemittierenden Bauelements mit zumindest einer organischen funktionellen Schicht anzugeben. Weiterhin ist es eine Aufgabe von zumindest einer Ausführungsform, ein organisches strahlungsemittierendes Bauelement mit zumindest einer organischen funktionellen Schicht anzugeben.
Diese Aufgaben werden durch ein Verfahren und einen Gegenstand mit den Merkmalen der unabhängigen Patentansprüche gelöst. Vorteilhafte Ausführungsformen und Weiterbildungen des Verfahrens und des Gegenstandes sind in den abhängigen Ansprüchen gekennzeichnet und gehen weiterhin aus der nachfolgenden Beschreibung und den Zeichnungen hervor.
Gemäß einer Ausführungsform umfasst ein Verfahren zur Herstellung eines organischen strahlungsemittierenden Bauelements insbesondere die Verfahrensschritte
A) Bereitstellen einer ersten Elektrodenschicht auf einem Substrat,
B) Aufbringen einer strukturierten elektrisch leitenden Schicht auf der ersten Elektrodenschicht, wobei die elektrisch leitende Schicht ein Metall aufweist,
C) Erzeugen einer elektrisch isolierenden Schicht umfassend ein Oxid des Metalls der elektrisch leitenden Schicht auf von der ersten Elektrodenschicht abgewandten Oberflächen der elektrisch leitenden Schicht durch Oxidation des Metalls, wobei die elektrisch isolierende Schicht mit einer Dicke von größer oder gleich 5 Nanometer und kleiner oder gleich 100 Nanometer erzeugt wird,
D) Aufbringen von zumindest einer organischen funktionellen Schicht auf der ersten Elektrodenschicht und der elektrisch isolierenden Schicht und
E) Aufbringen einer zweiten Elektrodenschicht auf der zumindest einen organischen funktionellen Schicht.

Gemäß einer weiteren Ausführungsform umfasst ein organisches strahlungsemittierendes Bauelement insbesondere
- eine erste Elektrodenschicht auf einem Substrat,
- eine strukturierte elektrisch leitende Schicht umfassend ein Metall auf der ersten Elektrodenschicht,
- eine elektrisch isolierende Schicht umfassend ein Oxid des Metalls der strukturierten elektrisch leitenden Schicht, die auf einer von der ersten Elektrodenschicht abgewandten Oberfläche der elektrisch leitenden Schicht angeordnet ist und die eine Dicke von größer oder gleich 5 Nanometer und kleiner oder gleich 100 Nanometer aufweist,
- zumindest eine organische funktionelle Schicht, die auf der ersten Elektrodenschicht und der elektrisch isolierenden Schicht angeordnet ist, und
- eine zweite Elektrodenschicht, die auf der zumindest einen organischen funktionellen Schicht angeordnet ist.

Alle im Folgenden beschriebenen Merkmale, weiteren Ausführungsformen und Vorteile beziehen sich gleichermaßen auf das vorab genannte Verfahren und auf das vorab genannte organische strahlungsemittierende Bauelement.

Dass eine Schicht oder ein Element "auf" oder "über" einer anderen Schicht oder einem anderen Element angeordnet oder aufgebracht ist, kann dabei hier und im Folgenden bedeuten, dass die eine Schicht oder das eine Element unmittelbar in direktem mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht beziehungsweise zwischen dem einen und dem anderen Element angeordnet sein.

Dass eine Schicht oder ein Element "zwischen" zwei anderen Schichten oder Elementen angeordnet ist, kann hier und im Folgenden bedeuten, dass die eine Schicht oder das eine Element unmittelbar in direktem mechanischen und/oder elektrischen Kontakt oder in mittelbarem Kontakt zur einen der zwei anderen Schichten oder Elementen und in direktem mechanischen und/oder elektrischen Kontakt oder in mittelbarem Kontakt zur anderen der zwei anderen Schichten oder Elementen angeordnet ist. Dabei können bei mittelbarem Kontakt dann weitere Schichten und/oder Elemente zwischen der einen und zumindest einer der zwei anderen Schichten beziehungsweise zwischen dem einen und zumindest einem der zwei anderen Element angeordnet sein.

Die zumindest eine organische funktionelle Schicht kann, wie weiter unten beschrieben ist, geeignet sein, im Betrieb des organischen strahlungsemittierenden Bauelements elektromagnetische Strahlung zu erzeugen und abzustrahlen. Die Bezeichnungen "Strahlung", "elektromagnetische Strahlung" und "Licht" bedeuten hier und im Folgenden elektromagnetische Strahlung mit zumindest einer Wellenlänge beziehungsweise einer spektralen Komponente in einem infraroten bis ultravioletten Wellenlängenbereich. Insbesondere kann infrarotes, sichtbares und/oder ultraviolettes Licht bezeichnet sein.

Durch die strukturierte elektrisch leitende Schicht auf der ersten Elektrodenschicht kann es möglich sein, den elektrischen Widerstand der ersten Elektrodenschicht entlang der Ersteckungsrichtung und/oder -ebene der ersten Elektrodenschicht zu verringern. Dadurch kann mittels des hier beschriebenen Verfahrens ein organisches strahlungsemittierendes Bauelement hergestellt werden, das im Vergleich zu einer OLED ohne elektrisch leitende Schicht eine größere Homogenität der Stromdichte in der ersten Elektrodenschicht und damit auch in der zumindest einen organischen funktionellen Schicht ermöglicht. Dadurch kann erreicht werden, dass auch die Homogenität der Leuchtdichte der in der zumindest einen organischen funktionellen Schicht erzeugten elektromagnetischen Strahlung im Vergleich zu herkömmlichen OLEDs verbessert wird.

Weiterhin kann ein organisches strahlungsemittierendes Bauelement geschaffen werden, bei dem die strukturierte elektrisch leitende Schicht zwar in direktem elektrischen Kontakt zur ersten Elektrodenschicht steht, nicht aber in direktem elektrischen Kontakt zur zumindest einen organischen funktionellen Schicht. Das kann dadurch erreicht werden, dass die elektrisch isolierende Schicht auf einer Oberfläche der elektrisch leitenden Schicht erzeugt wird, die von der ersten Elektrodenschicht abgewandt angeordnet sind. Insbesondere kann die Oberfläche der elektrisch leitenden Schicht, auf der die elektrisch isolierende Schicht erzeugt wird, zumindest alle die von der ersten Elektrodenschicht abgewandten Oberflächen der elektrisch leitenden Schicht umfassen, die an die zumindest eine organische funktionelle Schicht angrenzen. Dadurch kann erreicht werden, dass die elektrisch leitende Schicht nach der Durchführung der Verfahrensschritte C und D in keinem direkten elektrischen Kontakt mit der zumindest einen organischen funktionellen Schicht steht.

Weiterhin kann die Oberfläche der elektrisch leitenden Schicht, auf der die elektrisch isolierende Schicht erzeugt wird, alle von der ersten Elektrodenschicht abgewandten Oberflächen der elektrisch leitenden Schicht umfassen, so dass die elektrisch leitende Schicht nach der Durchführung des Verfahrensschritts C von der ersten Elektrodenschicht und der elektrisch isolierenden Schicht gänzlich umschlossen ist.

Dabei kann hier und im Folgenden das Merkmal, dass zwei Schichten oder Elemente in "direktem elektrischen Kontakt" stehen, bedeuten, dass die zwei Schichten oder Elemente direkt und unmittelbar aneinander angrenzen und eine gemeinsame Grenzfläche aufweisen. Dabei kann über die Grenzfläche ein Ladungsträgeraustausch, also ein elektrischer Stromfluss, zwischen den zwei Schichten oder Elementen stattfinden. Bei dem hier beschriebenen organischen strahlungsemittierenden Bauelement hingegen steht die Oberfläche der elektrisch leitenden Schicht, auf der die elektrisch isolierende Schicht angeordnet ist, gerade wegen der elektrisch isolierenden Schicht in keinem direkten elektrischen Kontakt zur organischen funktionellen Schicht, da über die Oberfläche mit der elektrisch isolierenden Schicht keine Ladungsträger zwischen der elektrisch leitenden Schicht und der zumindest einen organischen funktionellen Schicht ausgetauscht werden können.

Durch die Erzeugung der elektrisch isolierenden Schicht auf einer Oberfläche der elektrisch leitenden Schicht und bevorzugt zumindest auf allen von der ersten Elektrodenschicht abgewandten Oberflächen der elektrisch leitenden Schicht, die an die zumindest ein organische funktionelle Schicht direkt angrenzen, kann erreicht werden, dass die Stromdichte in der ersten Elektrodenschicht homogenisiert wird und gleichzeitig aber nur zwischen der ersten Elektrodenschicht und der organischen funktionellen Schicht ein Ladungsträgeraustausch und damit ein elektrischer Stromfluss stattfinden kann.

Dadurch kann beispielsweise verhindert werden, dass der im Vergleich zum Abstand zwischen der ersten und zweiten Elektrodenschicht geringere Abstand zwischen der strukturierten elektrisch leitenden Schicht und der zweiten Elektrodenschicht zu höheren elektrischen Feldstärken in Bereichen zwischen der elektrisch leitenden Schicht und der zweiten Elektrodenschicht im Betrieb des organischen strahlungsemittierenden Bauelements führt, was wiederum zu einem höheren Stromfluss und zu einer erhöhten Lichterzeugung in diesen Bereichen führen würde. Durch die elektrisch isolierende Schicht können somit im Betrieb des organischen strahlungsemittierenden Bauelements unerwünschte Inhomogenitäten in der Stromdichte und damit auch in der Leuchtdichte des organischen strahlungsemittierenden Bauelements verhindert oder zumindest verringert werden. Zudem könnte es bei nichtvorhandener elektrisch isolierenden Schicht aufgrund der höheren elektrischen Feldstärken in Bereichen zwischen der elektrisch leitenden Schicht und der zweiten Elektrodenschicht zu höheren elektrischen Strömen in diesen Bereichen kommen, die eine beschleunigte lokale Degradation der Materialien der Schichten des Bauelements bis hin zu einem Kurzschluss zur Folge haben kann, was einen Ausfall des gesamten organischen strahlungsemittierenden Bauelements zur Folge haben würde. In organischen Bauelementen, die Licht durch eine untere, transparente Elektrode und ein transparentes Substrat auskoppeln, kann die Lichtabstrahlung zur Betrachterseite hin durch die transparente Elektrodenschicht und das transparente Substrat hindurch durch elektrisch leitende Schicht verdeckt sein, so dass die Erzeugung von Licht in den Bereichen der elektrisch leitenden Schicht zu Verlusten führen und daher unerwünscht sein kann.

Durch die Erzeugung der elektrisch isolierenden Schicht auf der elektrisch leitenden Schicht kann somit ein Bauelement herstellbar sein oder hergestellt werden, in dem im Betrieb ein elektrischer Ladungsträgeraustausch und damit ein elektrischer Stromfluss zwar zwischen der ersten Elektrodenschicht und der organischen funktionellen Schicht, nicht aber zwischen der strukturierten elektrisch leitenden Schicht und der organischen funktionellen Schicht erfolgt, so dass elektrische Ladungsträger von Seiten der ersten Elektrodenschicht nur aus der ersten Elektrodenschicht in die organische funktionelle Schicht gelangen können, nicht aber aus der elektrisch leitenden Schicht. Dadurch kann eine Funktionstrennung der elektrisch leitenden Schicht und der ersten Elektrodenschicht erreicht derart werden, dass die elektrisch leitende Schicht trotz ihrer Anordnung zwischen der ersten Elektrodenschicht und der organischen funktionellen Schicht nur zur Homogenisierung der Stromdichte in der ersten Elektrodenschicht dient.

Durch das Erzeugen der elektrisch isolierenden Schicht durch Oxidation des Metalls der elektrisch leitenden Schicht kann weiterhin mit Vorteil sichergestellt werden, dass die elektrisch isolierende Schicht im Verfahrensschritt C ausschließlich auf der elektrisch leitenden Schicht erzeugt wird und damit nur auf der zumindest einen Oberfläche der elektrisch leitenden Schicht oder weiterhin auch bevorzugt nur auf allen von der ersten Elektrodenschicht abgewandten Oberflächen der elektrisch leitenden Schicht, die direkt an die organische funktionelle Schicht angrenzen, angeordnet ist.

Im Gegensatz zum hier beschriebenen Verfahren wird bei bisher bekannten Verfahren zur elektrischen Isolation einer elektrisch leitenden Schicht durch Abscheidung in einem weiteren Prozessschritt eine zusätzliche Isolationsschicht aufgebracht. Diese kann beispielsweise durch eine entsprechende Maske aufgedampft werden oder durch lithographische Strukturierung an die Form der zu isolierenden elektrisch leitenden Schicht angepasst werden. Derartige bekannte Verfahren haben jedoch den Nachteil, dass die Positionierung der Isolationsschicht mit hoher Präzision und Güte erfolgen muss. Würde ein derartiges bekanntes Verfahren im Zusammenhang mit der hier beschriebenen ersten Elektrodenschicht und der elektrisch leitenden Schicht angewandt, würde ein Überlapp der Isolationsschicht mit der ersten Elektrodenschicht, also eine zu breite Isolationsschicht, zur einer unnötigen und unvorteilhaften Verringerung der lichtemittierenden Fläche führen. Eine zu schmale Isolationsschicht würde hingegen zu den oben genannten Problemen wie beispielsweise der Ausbildung von erhöhten elektrischen Feldstärken im Bereich der strukturierten elektrisch leitenden Schicht an den Stellen führen, an denen die zu schmale Isolationsschicht die elektrisch leitende Schicht nicht von der organischen funktionellen Schicht elektrisch isoliert.

Mittels des hier beschriebenen Verfahrens wird die Oberfläche der elektrisch leitenden Schicht selbst passiviert und damit derart umgewandelt, dass die elektrisch isolierende Schicht erzeugt wird. Dazu wird das Metall der elektrisch leitenden Schicht in ein Oxid mit dem Metall, im Folgenden auch als das Metalloxid des Metalls der elektrisch leitenden Schicht bezeichnet, umgewandelt. Dies kann durch die Oxidation der zumindest einen Oberfläche oder auch aller Oberflächen der elektrisch leitenden Schicht, die von der ersten Elektrodenschicht abgewandt angeordnet sind, erfolgen. Durch die Oxidation im Verfahrensschritt C und die Erzeugung der elektrisch isolierenden Schicht kann somit ermöglicht werden, dass die elektrisch leitende Schicht gegenüber der organischen funktionellen Schicht passiviert, also elektrisch isoliert wird. Dabei kann es zur Ausbildung einer gleichmäßigen elektrisch isolierenden Schicht umfassend das Metalloxid auf allen von der ersten Elektrodenschicht abgewandten Oberflächen der elektrisch leitenden Schicht kommen, ohne dass ein oben erwähnter zusätzlicher Aufbring-Prozessschritt im Vakuum oder mit zeit- und kostenintensiven Lithographietechniken notwendig ist, um eine zusätzliche Isolatorschicht auf der elektrisch leitenden Schicht aufzubringen.

Weiterhin kann die elektrisch leitende Schicht im Verfahrensschritt C durch eines oder mehrere der folgenden Verfahren oxidiert werden: eine Plasmabehandlung, insbesondere eine Behandlung der ersten Elektrodenschicht und der strukturierten elektrisch leitenden Schicht in einem Sauerstoffplasma, eine UV-Ozon-Behandlung, reaktives Ionenätzen und/oder eine nass-chemische Behandlung. Insbesondere kann die Oxidation im Verfahrensschritt C auch durch eine Kombination dieser Verfahren oder eine Anwendung zweier oder mehrerer dieser Verfahren nacheinander erfolgen.

Ferner kann im Verfahrensschritt C die erste Elektrodenschicht hinsichtlich ihrer Benetzungseigenschaft für die zumindest eine organische funktionelle Schicht und/oder ihre elektrische Austrittsarbeit für elektrische Ladungsträger modifiziert werden. Das kann bedeuten, dass durch das Verfahren im Verfahrensschritt C, durch das die Oberfläche der elektrisch leitenden Schicht oxidiert wird, ebenfalls und gleichzeitig die erste Elektrodenschicht derart modifiziert wird, dass die vorab genannten Eigenschaften verbessert werden. Weiterhin kann es möglich sein, die erste Elektrodenschicht durch den Verfahrensschritt C gleichzeitig zur Oxidation der Oberfläche der elektrisch leitenden Schicht zu reinigen, beispielsweise um organische Reste und Verunreinigungen von der ersten Elektrodenschicht vor dem Verfahrensschritt D zu entfernen. Dabei wurde im Falle des hier beschriebenen Verfahrens festgestellt, dass die Reinigung und die Verbesserung oder sogar die Optimierung der Austrittsarbeit und der Benetzungseigenschaft der ersten Elektrodenschicht in ein und demselben Verfahrensschritt C durchgeführt werden kann wie die Oxidation der Oberfläche der elektrisch leitenden Schicht. Somit ist bei dem hier beschriebenen Verfahren die Integration dieser Effekte in demselben Verfahrensschritt möglich. Daher kann im hier beschriebenen Verfahren für eine Verbesserung beziehungsweise Optimierung der vorab genannten Eigenschaften der ersten Elektrodenschicht auf einen zusätzlichen Prozessschritt verzichtet werden.

Durch die Oxidation kann es zum Einbau von Sauerstoffatomen in das Kristallgitter des Metalls der elektrisch leitenden Schicht unter Bildung des Metalloxids kommen. Je nach Verfahrensbedingungen beim Verfahrensschritt C kann dabei das Metalloxid in einem im Wesentlichen scharf abgegrenzten Dickenbereich der Oberfläche der elektrisch leitenden Schicht gebildet werden. Das kann bedeuten, dass das Metalloxid in dem besagten Dickenbereich gänzlich oder zumindest überwiegend in einem stöchiometrischen Verhältnis der Metallatome und der Sauerstoffatome vorliegt und in Form von Metalloxid-Schichten oder -Schichtbereichen charakterisierbar ist. Weiterhin kann je nach Verfahrensbedingungen im Verfahrensschritt C der Sauerstoffgehalt ab einer bestimmten Tiefe in der elektrisch isolierenden Schicht abfallen. Dieser Abfall des Sauerstoffgehalts kann beispielsweise exponentiell oder nahezu exponentiell erfolgen. Dadurch kann der Übergang zwischen der elektrisch leitenden Schicht und der elektrisch isolierenden Schicht kontinuierlich sein, ohne dass es zur Ausbildung einer scharfen Grenzfläche zwischen der elektrisch leitenden und der elektrisch isolierenden Schicht kommt. Die Grenze zwischen der elektrisch isolierenden Schicht und der elektrisch leitenden Schicht kann dabei beispielsweise der Bereich in der elektrisch leitenden beziehungsweise der elektrisch isolierenden Schicht sein, in dem der Gehalt der Sauerstoffatome auf 1/e oder (1/e)² des stöchiometrischen Sauerstoffgehalts des Metalloxids abgefallen ist, wobei e die Eulersche Zahl bezeichnet.

Die strukturierte elektrisch leitende Schicht kann im Verfahrensschritt B beispielsweise mit einer ersten Dicke aufgebracht werden. Durch die Oxidation des Metalls an der zumindest einen von der ersten Elektrodenschicht abgewandten Oberfläche der elektrisch leitenden Schicht im Verfahrensschritt C und die damit verbundene Erzeugung der elektrisch isolierenden Schicht kann die Gesamtdicke der elektrisch leitenden Schicht und der elektrisch isolierenden Schicht in diesem Bereich durch den Einbau von Sauerstoffatomen in das Metall unter Bildung des Metalloxids größer als die erste Dicke der elektrisch leitenden Schicht nach dem Verfahrensschritt B sein. Weiterhin kann nach dem Verfahrensschritt C die Dicke der verbleibenden elektrisch leitenden Schicht kleinere sein als die erste Dicke der ursprünglich aufgebrachten elektrisch leitenden Schicht nach dem Verfahrensschritt B.

Im Verfahrensschritt B kann als Metall der elektrisch leitenden Schicht ein unedles Metall aufgebracht werden, das zumindest mittels eines der vorab genannten Verfahren oxidierbar ist. Insbesondere wird im Verfahrensschritt B ein Metall aufgebracht, dessen Oxid elektrisch isolierend ist. Beispielsweise kann das Metall Titan, Magnesium, Zirconium und/oder Aluminium aufweisen oder daraus bestehen. Damit kann die elektrisch isolierende Schicht nach dem Verfahrensschritt C Titanoxid, Magnesiumoxid, Zirconiumoxid und/oder Aluminiumoxid aufweisen oder daraus bestehen. Hierbei sei darauf hingewiesen, dass die hier und im Folgenden beschriebenen Metalloxide grundsätzlich elektrisch isolierende Oxide eines Metalls und damit Oxide mit Metallen mit entsprechenden Oxidationsstufen bezeichnen, auch wenn beispielsweise noch andere elektrisch leitende Oxide eines genannten Metalls bei gewissen Oxidationsstufen des Metalls bekannt sein sollten.

Besonders bevorzugt wird im Verfahrensschritt B Aluminium als elektrisch leitende Schicht auf der ersten Elektrodenschicht aufgebracht. Während Aluminium an Luft unter Normalbedingungen eine dünne Oxidschicht auf allen Oberflächen ausbildet, kann der Verfahrensschritt B unter Ausschluss von Sauerstoff beispielsweise im Vakuum oder in einer Schutzgasatmosphäre durchgeführt werden, so dass im Verfahrensschritt C durch eines der vorab genannten Oxidationsverfahren gezielt die elektrisch isolierende Schicht mit einer gewünschten Dicke herstellbar ist.

Dabei kann insbesondere Aluminium einen so genannten Selbstpassivierungseffekt aufweisen, was bedeuten kann, dass die Oxidation bei einer gewissen, beispielsweise durch die Verfahrensparameter einstellbaren Dicke, von selbst stoppt.

Das Substrat mit der elektrisch leitenden Schicht und darüber mit der elektrisch isolierenden Schicht kann nach dem Verfahrensschritt C auch außerhalb der Schutzgasatmosphäre weiter verarbeitbar und/oder lagerbar sein, ohne dass die elektrisch leitende Schicht durch schädigende Einflüsse wie etwa Feuchtigkeit und/oder Sauerstoff beschädigt werden würde.

Die Dicke der im Verfahrensschritt C herstellbaren elektrisch isolierenden Schicht umfassend das Metalloxid kann dabei zumindest die Dicke einer Monolage des Metalloxids aufweisen. Insbesondere ist die Dicke der elektrisch isolierenden Schicht größer oder gleich 5 Nanometer, um eine ausreichende elektrische Isolation der elektrisch leitenden Schicht zu ermögliche. Weiterhin ist die Dicke der elektrisch isolierenden Schicht kleiner oder gleich 100 Nanometer und kann insbesondere auch kleiner oder gleich 25 Nanometer sein. Je dünner die elektrisch isolierende Schicht ausgebildet wird, desto geringer ist auch die Gesamtdicke der elektrisch leitenden Schicht und der elektrisch isolierenden Schicht, so dass mit Vorteil keine unnötige optische Abschattung durch die elektrisch leitende und die elektrisch isolierende Schicht im Betrieb des organischen strahlungsemittierenden Bauelements wahrnehmbar ist.

Die Dicke der organischen funktionellen Schicht kann weiterhin größer als die Gesamtdicke der elektrisch leitenden Schicht und der elektrisch isolierenden Schicht zusammen sein, so dass die organische funktionelle Schicht die elektrisch leitende und die elektrisch isolierende Schicht überdeckt und die durch diese bedingten Unebenheiten auf der ersten Elektrodenschicht planarisiert.

Weiterhin kann die elektrisch leitende Schicht im Verfahrensschritt B durch Sputtern oder Verdampfen aufgebracht werden. Dabei kann die elektrisch leitende Schicht bevorzugt im Verfahrensschritt B streifenförmig strukturiert werden und einen oder eine Mehrzahl von Streifen oder Stegen umfassen. Die elektrisch leitende Schicht kann dabei beispielsweise großflächig und unstrukturiert auf der ersten Elektrodenschicht aufgebracht werden und anschließend mittels einer Maske streifenförmig strukturiert werden. Dabei können Bereiche der großflächig aufgebrachten elektrisch leitenden Schicht mittels bekannten trocken- oder nasschemischen Ätzprozessen, beispielsweise auch unter Verwendung von strukturierten Photoresist-Masken, von der ersten Elektrodenschicht entfernt werden. Alternativ kann die erste Elektrodenschicht im Verfahrensschritt B mittels einer Maske bereits streifenförmig strukturiert aufgedampft oder aufgesputtert werden.

Weiterhin kann auch ein Druckverfahren wie etwa Siebdruck verwendet werden oder auch ein Aufsprühverfahren ("spray coating") durch eine Maske.

Die elektrisch leitende Schicht kann im Verfahrensschritt B in Form von Streifen mit einer Breite von kleiner oder gleich 100 Mikrometer und größer oder gleich 100 Nanometer aufgebracht werden. Die einzelnen Streifen können sich dabei gleichmäßig oder in Mustern über Teilbereiche oder über die gesamte erste Elektrodenschicht erstrecken und beispielsweise gerade oder gebogen und weiterhin parallel nebeneinander, sternförmig und/oder netzförmig angeordnet sein. Beispielsweise kann die erste Elektrodenschicht einen elektrischen Kontaktbereich zum elektrischen Anschluss der ersten Elektrodenschicht an eine externe Spannungs- und/oder Stromversorgung aufweisen. In diesem Fall können sich Streifen der elektrisch leitenden Schicht bevorzugt vom elektrischen Kontaktbereich wegerstrecken.

Alternativ oder zusätzlich zur streifenförmigen Strukturierung kann die elektrisch leitende Schicht im Verfahrensschritt B auch in ein Form einer anderen geometrischen Form strukturiert werden, die geeignet ist, eine homogene Stromdichteverteilung in der ersten Elektrodenschicht und in der zumindest einen organischen funktionellen Schicht zu bewirken.

Weiterhin kann im Verfahrensschritt A das Substrat mit der ersten Elektrodenschicht und einer weiteren elektrisch leitenden Schicht zwischen dem Substrat und der ersten Elektrodenschicht bereitgestellt werden. Durch die weitere elektrisch leitende Schicht, die auf der dem Substrat zugewandten Oberfläche der ersten Elektrodenschicht angeordnet sein kann, kann die Querleitfähigkeit der ersten Elektrodenschicht weiter erhöht werden und somit eine weitere Homogenisierung der Stromdichte in der ersten Elektrodenschicht bewirkt werden.

Insbesondere kann das organische strahlungsemittierende Bauelement als organische, strahlungsemittierende Diode (OLED) ausgeführt sein. Das organische strahlungsemittierende Bauelement kann dazu einen aktiven Bereich aufweisen, der geeignet ist, im Betrieb elektromagnetische Strahlung abzustrahlen. Das organische strahlungsemittierende Bauelement kann eine organische strahlungsemittierende Schichtenfolge aufweisen, die die erste Elektrodenschicht, die zweite Elektrodenschicht und zwischen diesen eine organische Schichtenfolge umfassend die zumindest eine organische funktionelle Schicht aufweist. Die organische Schichtenfolge kann zusätzlich zu zumindest einen organischen funktionellen Schicht eine Mehrzahl von weiteren organischen funktionellen Schichten aufweisen. Die zumindest eine organische funktionelle Schicht oder die Mehrzahl der funktionellen Schichten können dabei beispielsweise Elektronentransportschichten, elektrolumineszierende Schichten und/oder Löchtransportschichten aufweisen oder als solche ausgeführt sein. Die organische Schichtenfolge kann den aktiven Bereich umfassen, in dem durch rekombination von Elektronen und Löchern elektromagnetische Strahlung erzeugt werden kann.

Die erste und/oder die zweite Elektrodenschicht können jeweils großflächig ausgebildet sein. Dadurch kann eine großflächige Abstrahlung der im aktiven Bereich erzeugten elektromagnetischen Strahlung ermöglicht werden. "Großflächig" kann dabei bedeuten, dass das organische elektronische Bauelement eine Fläche von größer oder gleich einigen Quadratmillimetern, bevorzugt größer oder gleich einem Quadratzentimeter und besonders bevorzugt größer oder gleich einem Quadratdezimeter aufweist. Alternativ oder zusätzlich können die erste und/oder die zweite Elektrode zumindest in Teilbereichen strukturiert ausgebildet sein. Dadurch kann eine strukturierte Abstrahlung der im aktiven Bereich erzeugten elektromagnetischen Strahlung ermöglicht werden, etwa in Form von Pixeln oder Piktogrammen. Durch die elektrisch leitende Schicht auf der ersten Elektrodenschicht kann eine gleichmäßiger und lateral homogenere Bestromung des aktiven Bereichs ermöglich werden als dies bei OLEDs ohne eine hier beschriebene elektrisch leitende Schicht der Fall ist. Durch die gleichmäßigere und lateral homogenere Bestromung kann eine homogene Leuchtfläche des organischen strahlungsemittierenden Bauelements erreicht werden.

Beispielsweise kann das Substrat Glas, Quarz, Kunststofffolien, Metall, Metallfolien, Siliziumwafer oder ein anderes geeignetes Substratmaterial umfassen. Ist das organische strahlungsemittierende Bauelement als so genannter "Bottom-Emitter" ausgeführt, das heißt, dass die im aktiven Bereich erzeugte elektromagnetische Strahlung durch das Substrat abgestrahlt wird, so kann das Substrat eine Transparenz für zumindest einen Teil der ersten Strahlung aufweisen.

In der Bottom-Emitter-Konfiguration kann vorteilhafterweise auch die erste Elektrodeschicht eine Transparenz für zumindest einen Teil der im aktiven Bereich erzeugten elektromagnetischen Strahlung aufweisen. Eine transparente erste Elektrodeschicht, die als Anode ausgeführt sein kann und somit als löcherinjizierendes Material dient, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Die zumindest eine organische funktionelle Schicht oder die Mehrzahl davon können organische Polymere, organische Oligomere, organische Monomere, organische kleine, nichtpolymere Moleküle ("small molecules") oder Kombinationen daraus aufweisen. Geeignet Materialien für eine OLED sind dem Fachmann bekannt und werden hier nicht weiter ausgeführt. Abhängig von den Materialien in den funktionellen Schichten kann die erzeugte elektromagnetische Strahlung einzelne Wellenlängen oder Bereiche oder Kombinationen daraus aus dem ultravioletten bis rotem Spektralbereich aufweisen.

Die zweite Elektrodenschicht kann als Kathode ausgeführt sein und somit als elektroneninjizierendes Material dienen. Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen. Alternativ oder zusätzlich kann die zweite Elektrodenschicht auch eines der oben genannten TCOs aufweisen. Zusätzlich oder alternativ kann die zweite Elektrodenschicht auch transparent ausgeführt sein und/oder die erste Elektrodenschicht kann als Kathode und die zweite Elektrodenschicht als Anode ausgeführt sein. Das bedeutet insbesondere, dass das organische strahlungsemittierende Bauelement auch als "Top-Emitter" ausgeführt sein kann.

Weiterhin können die erste und/oder die zweite, Elektrodenschicht auch eines oder mehrere organische elektrisch leitende Materialien, etwa dotiertes oder undotiertes Polyanilin, Polypyrrol und/oder Polythiophen, und/oder Kohlenstoffnanoröhrchen ("carbon nanotubes", CNT) aufweisen.

Weiterhin kann das organische strahlungsemittierende Bauelement auch gleichzeitig als Bottom-Emitter und als Top-Emitter ausgeführt sein und eine transparente erste Elektrodenschicht und eine transparente zweite Elektrodenschicht aufweisen. Dadurch kann das organische strahlungsemittierende Bauelement transparent sein.

Weitere Vorteile, bevorzugte Ausführungsformen und Weiterbildungen des Verfahrens zur Herstellung eines organischen strahlungsemittierenden Bauelements sowie des organischen strahlungsemittierenden Bauelements ergeben sich aus dem im Folgenden und in Verbindung mit den Figuren erläuterten Ausführungsbeispiel.

Es zeigen:

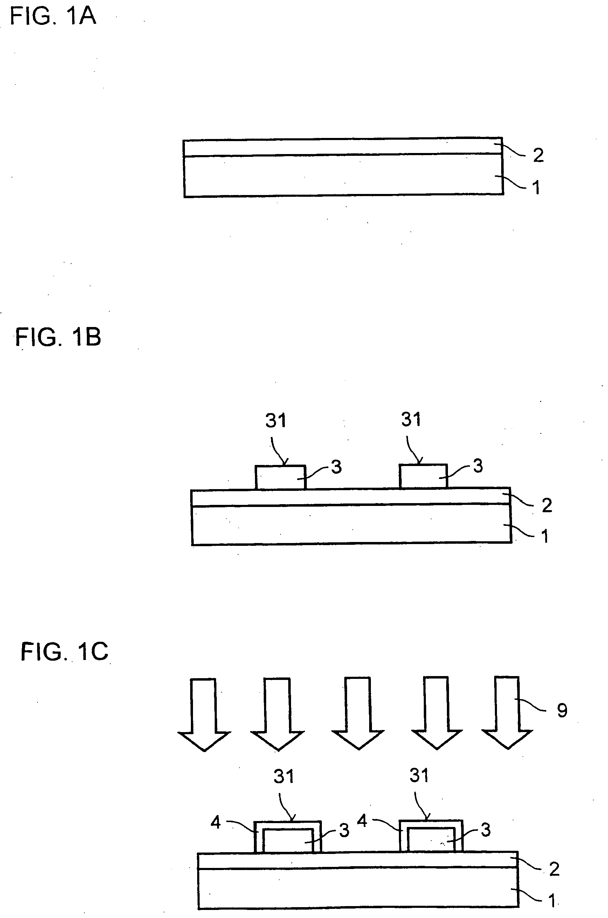

Figuren 1A bis 1E ein Verfahren zur Herstellung eines organischen strahlungsemittierenden Bauelements sowie ein organisches strahlungsemittierendes Bauelement gemäß einem Ausführungsbeispiel.

Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

In Figur 1A ist ein erster Verfahrensschritt A eines Verfahrens zur Herstellung eines organischen strahlungsemittierenden Bauelements gemäß einem Ausführungsbeispiel gezeigt. Dabei wird ein Substrat 1 mit einer ersten Elektrodenschicht 2 bereitgestellt. Im gezeigten Ausführungsbeispiel sind das Substrat 1 und die erste Elektrodenschicht 2 transparent ausgeführt. Dabei ist das Substrat 1 aus Glas und die erste Elektrodenschicht 2, die großflächig auf dem Substrat 1 aufgebracht ist, aus Indium-Zinn-Oxid (ITO). Im gezeigten Ausführungsbeispiel dient die erste Elektrodenschicht 2 als Anode und damit als Lochinjektionsschicht.

Alternativ dazu können das Substrat 1 und/oder die erste Elektrodenschicht 2 eines oder mehrere der im allgemeinen Teil beschriebenen Materialien aufweisen.

In Figur 1B ist ein weiterer Verfahrensschritt B gezeigt, in dem eine strukturierte elektrisch leitende Schicht 3 aufgebracht wird. Im gezeigten Ausführungsbeispiel wird dazu Aluminium mittels thermischen Verdampfens durch eine Schattenmaske (nicht gezeigt) hindurch auf der ersten Elektrodenschicht 2 abgeschieden. Die Schattenmaske ist dabei derart ausgeführt, dass sich die elektrisch leitende Schicht 3 auf der ersten Elektrodenschicht 2 in Streifen beziehungsweise streifenförmigen Bereichen ausbildet, die sich über die erste Elektrodenschicht 2 erstrecken und die aus Aluminium sind. Alternativ dazu kann auch eines der weiteren im allgemeinen Teil genannten Materialien oder eine Kombination daraus aufgebracht werden. Die Streifen der elektrisch leitenden Schicht 3 weisen dabei eine Breite von einigen Mikrometern auf. Je breiter die Streifen der elektrisch leitenden Schicht 3 ausgebildet sind und je geringer der Abstand zwischen jeweils benachbarten Steifen ist, desto besser kann die Stromdichte in der ersten Elektrodenschicht 2 homogenisiert werden. Je schmaler die Streifen der ersten Elektrodenschicht 2 sind und je größer der Abstand zwischen jeweils zwei benachbarten Streifen ist, desto mehr Licht kann später im Betrieb des organischen strahlungsemittierenden Bauelements durch die erste Elektrodenschicht 2 und das Substrat 1 hindurch abgestrahlt werden.

Weist die erste Elektrodenschicht 2 einen elektrischen Kontaktbereich zur elektrischen Kontaktierung auf, so ist es vorteilhaft, wenn sich die streifenförmigen Bereiche der elektrisch leitenden Schicht 3 vom elektrischen Kontaktbereich weg erstrecken und so eine effektive Erhöhung der Querleitfähigkeit beziehungsweise eine Erniedrigung des elektrischen Widerstands der ersten Elektrodenschicht 2 bewirken. Im späteren organischen strahlungsemittierenden Bauelement hat dies eine Homogenisierung der Stromdichte in der ersten Elektrodenschicht 2 und damit eine Homogenisierung des Leuchteindrucks über die gesamte Fläche der ersten Elektrodenschicht 3 beziehungsweise des in einem späteren Verfahrensschritt aufzubringenden aktiven Bereichs zur Folge.

Jeder streifenförmige Bereich der elektrisch leitenden Schicht 3 weist eine von der ersten Elektrodenschicht 2 abgewandte Oberfläche 31 auf, die nicht in direktem Kontakt mit der ersten Elektrodenschicht 2 steht. In einem weiteren Verfahrensschritt C wird auf dieser Oberfläche 31 eine elektrisch isolierende Schicht 4 mittels Oxidation 9 erzeugt, wie in Figur 1C gezeigt ist. Dazu wird das Substrat 1 mit der ersten Elektrodenschicht 2 und der strukturierten elektrisch leitende Schicht 3 einem Sauerstoff-Plasma ausgesetzt, was durch die Pfeile 9 angedeutet ist.

Das Sauerstoff-Plasma bewirkt, dass das Aluminium der elektrisch leitenden Schicht 3 auf der Oberfläche 31 oxidiert wird und eine Metalloxidschicht, im gezeigten Ausführungsbeispiel eine Aluminiumoxidschicht, als elektrisch isolierende Schicht 4 auf der Oberfläche 31 ausgebildet wird. Die elektrisch isolierende Schicht 4 weist nach dem Verfahrensschritt C eine Dicke von etwa 5 bis 25 Nanometer auf. Durch die Einwirkung des Sauerstoff-Plasmas oder alternativ oder zusätzlich einer der weitern im allgemeinen Teil genannten Oxidationsverfahren wie etwa eine UV-Ozon-Behandlung oder eine nasschemische Behandlung wird im gezeigten Ausführungsbeispiel die gesamte Oberfläche 31 der elektrisch leitenden Schicht 3 oxidiert und auf dieser die elektrisch isolierende Schicht 4 erzeugt, so dass die elektrisch leitende Schicht 3 nach der Oxidation gänzlich von der elektrisch isolierenden Schicht 4 und der ersten Elektrodenschicht 2 umschlossen ist. Dadurch steht die elektrisch leitende Schicht 3 ausschließlich mit der ersten Elektrodenschicht 2 in direktem elektrischen Kontakt, wodurch, wie im allgemeinen Teil beschrieben ist, beispielsweise im Betrieb des organischen strahlungsemittierenden Bauelements die Ausbildung von Bereichen mit zu hohen elektrischen Feldstärken in Bereichen nahe der elektrisch leitenden Schicht 3 vermieden werden können.

Weiterhin wird die elektrisch isolierende Schicht 4 durch die Oxidation der Oberfläche 31 genau auf der elektrisch leitenden Schicht 3, nicht aber auf der ersten Elektrodenschicht 2, erzeugt. Dadurch kann mit Vorteil sichergestellt werden, dass die elektrisch isolierende Schicht 4 keinen Bereich der ersten Elektrodenschicht 2 unnötigerweise abdeckt, was zu einer Verringerung der durch die erste Elektrodenschicht 2 und das Substrat 1 abgestrahlten Lichtleistung führen würde. Andererseits kann durch das hier beschriebene Verfahren sichergestellt werden, dass auf der gesamten Oberfläche 31 der elektrisch leitenden Schicht 3 die elektrisch isolierende Schicht 4 ausgebildet wird.

Darüber hinaus wird durch das Sauerstoff-Plasma erreicht, dass die Benetzbarkeit der ersten Elektrodenschicht 2 erhöht sowie die Austrittsarbeit für Ladungsträger aus dem ITO der ersten Elektrodenschicht 2 verringert wird. Weiterhin können durch das Sauerstoff-Plasma beispielsweise organische Verunreinigungen auf der ersten Elektrodenschicht 2 entfernt werden. Da diese Effekte die erste Elektrodenschicht 2 betreffend gleichzeitig mit der Oxidation 9 der elektrisch leitenden Schicht 2 zur Erzeugung der elektrisch isolierenden Schicht 4 erreicht werden können, ist im Vergleich zu bekannten Herstellungsverfahren von OLEDs kein zusätzlicher entsprechender Prozessschritt mehr nötig.

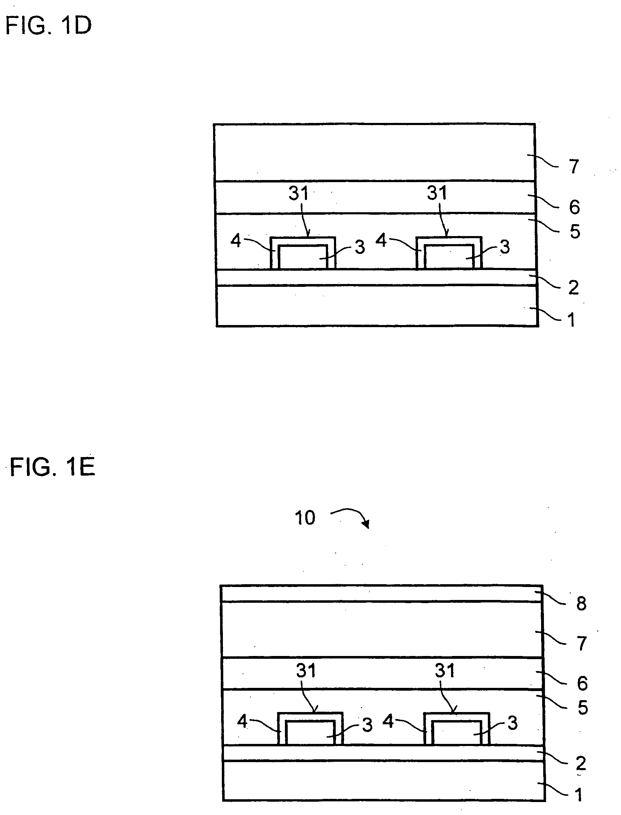

In Figur 1D ist ein weiterer Verfahrensschritt D gezeigt, in dem eine organische funktionelle Schicht 5 auf der elektrisch isolierenden Schicht 4 und der ersten Elektrodenschicht 2 aufgebracht wird. Dabei ist die organische funktionelle Schicht 5 als Lochtransportschicht ausgebildet und weist eine Dicke auf, die größer als die Gesamtdicke der elektrisch leitenden Schicht 3 und der elektrisch isolierenden Schicht 4 ist. Die organische funktionelle Schicht 5 überdeckt somit die elektrisch leitende Schicht und die elektrisch isolierende Schicht 4 vollständig. Mit anderen Worten ausgedrückt ragt die elektrisch leitende Schicht 3 mit der elektrisch isolierenden Schicht 4 darauf in die organische funktionelle Schicht 5 hinein. Dabei wird durch die elektrisch isolierende Schicht 4 ein direkter elektrischer Kontakt zwischen der elektrisch leitenden Schicht 3 und der organischen funktionellen Schicht 5 verhindert, so dass nur über die erste Elektrodenschicht 2 von der Substratseite her in die organische funktionelle Schicht 5 injiziert werden können.

Auf der organischen funktionellen Schicht 5 werden weitere organische funktionelle Schichten aufgebracht, wobei im dargestellten Ausführungsbeispiel rein beispielhaft eine den aktiven Bereich bildende Emitterschicht 6 und darüber einen Elektronentransportschicht 7 gezeigt sind. Je nach Materialien, also Polymeren oder organischen kleinen Molekülen ("small molecules"), der organischen funktionellen Schicht 5, 6 und 7 können beispielsweise auch weitere organische funktionelle Schicht wie etwa Ladungsträgerblockierschichten oder auch weniger funktionelle Schichten aufgebracht werden.

In einem weiteren Verfahrensschritt E, der in Figur 1E gezeigt ist, wird eine zweite Elektrodenschicht 8 mit einem Metall als Kathode aufgebracht und das organische strahlungsemittierende Bauelement 10 damit fertig gestellt. Zusätzlich kann im Verfahrensschritt E beispielsweise noch eine Verkapselung (nicht gezeigt) über der zweiten Elektrodenschicht 8 aufgebracht werden, um das organische strahlungsemittierende Bauelement 10 vor schädigenden Einflüssen wie etwa Feuchtigkeit oder Sauerstoff zu schützen.

Alternativ zum gezeigten Ausführungsbeispiel können die erste Elektrodenschicht 2 auch als Kathode und die zweite Elektrodenschicht 8 als Anode ausgebildet sein. Dabei können eine der beiden Elektrodenschichten 2, 8 oder auch beide transparent ausgeführt sein. Die organische funktionelle Schicht 5 ist dann als Elektrodentransportschicht ausgebildet, während die organische funktionelle Schicht 7 dann als Lochtransportschicht ausgeführt ist.

## Patentansprüche

1. Verfahren zur Herstellung eines organischen strahlungsemittierenden Bauelements, umfassend die Verfahrensschritte:
A) Bereitstellen einer ersten Elektrodenschicht (2) auf einem Substrat (1),
B) Aufbringen einer strukturierten elektrisch leitenden Schicht (3) auf der ersten Elektrodenschicht (2), wobei die elektrisch leitende Schicht (3) ein Metall aufweist,
C) Erzeugen einer elektrisch isolierenden Schicht (4) umfassend ein Oxid des Metalls der elektrisch leitenden Schicht (3) auf von der ersten Elektrodenschicht (2) abgewandten Oberflächen (31) der elektrisch leitenden Schicht (3) durch Oxidation des Metalls,
D) Aufbringen von zumindest einer organischen funktionellen Schicht (5) auf der ersten Elektrodenschicht (2) und der elektrisch isolierenden Schicht (4) und
E) Aufbringen einer zweiten Elektrodenschicht (9) auf der zumindest einen organischen funktionellen Schicht (5), **dadurch gekennzeichnet, dass**
- im Verfahrensschritt C die elektrisch isolierende Schicht (4) mit einer Dicke von größer oder gleich 5 Nanometer und kleiner oder gleich 100 Nanometer erzeugt wird.

2. Verfahren nach Anspruch 1, bei dem
- im Verfahrensschritt C durch ein Verfahren oder eine Kombination von Verfahren oxidiert wird, die ausgewählt sind aus einer Gruppe, die gebildet wird durch eine Sauerstoff-Plasmabehandlung, eine UV-Ozon-Behandlung, reaktives Ionenätzen und eine nass-chemische Behandlung.

3. Verfahren nach einem der vorherigen Ansprüche, bei dem
- im Verfahrensschritt C die erste Elektrodenschicht (2) hinsichtlich ihrer Benetzungseigenschaft und/oder ihrer elektrischen Austrittsarbeit für Ladungsträger modifiziert wird.

4. Verfahren nach einem der vorherigen Ansprüche, bei dem
- im Verfahrensschritt B als Metall der elektrisch leitenden Schicht (3) ein unedles Metall aufgebracht wird, dessen Oxid elektrisch isolierend ist.

5. Verfahren nach einem der vorhergehenden Ansprüche, bei dem
- die strukturierte elektrisch leitende Schicht Ti oder Mg aufweist.

6. Verfahren nach einem der vorherigen Ansprüche, bei dem
- im Verfahrensschritt B die elektrisch leitende Schicht (3) durch Sputtern oder Verdampfen aufgebracht wird.

7. Verfahren nach einem der vorhergehenden Ansprüche, bei dem
- im Verfahrensschritt B die elektrisch leitende Schicht (3) streifenförmig strukturiert wird.

8. Verfahren nach Anspruch 7, bei dem
- sich zumindest ein Streifen der elektrisch leitenden Schicht (3) über einen Teilbereich der ersten Elektrodenschicht (2) erstreckt.

9. Organisches strahlungsemittierendes Bauelement, umfassend
- eine erste Elektrodenschicht (2) auf einem Substrat (1),
- eine strukturierte elektrisch leitende Schicht (3) umfassend ein Metall auf der ersten Elektrodenschicht (2),
- eine elektrisch isolierende Schicht (4) umfassend ein Oxid des Metalls der strukturierten elektrisch leitenden Schicht, die auf einer von der ersten Elektrodenschicht (2) abgewandten Oberfläche der elektrisch leitenden Schicht (3) angeordnet ist und die eine Dicke von größer oder gleich 5 Nanometer und kleiner oder gleich 100 Nanometer aufweist,
- zumindest eine organische funktionelle Schicht (5), die auf der ersten Elektrodenschicht (1) und der elektrisch isolierenden Schicht (4) angeordnet ist, und
- eine zweite Elektrodenschicht (9), die auf der zumindest einen organischen funktionellen Schicht (5) angeordnet ist.

10. Bauelement nach Anspruch 9, wobei
- die elektrisch leitende Schicht (3) ein unedles Metall aufweist, dessen Oxid elektrisch isolierend ist.

11. Bauelement nach Anspruch 9 oder 10, wobei die strukturierte elektrisch leitende Schicht Ti oder Mg aufweist.

12. Bauelement nach einem der Ansprüche 9 bis 11, wobei
- die elektrisch leitende Schicht (3) streifenförmig strukturiert ist.

13. Bauelement nach Anspruch 12, wobei
- die elektrisch leitende Schicht (3) zumindest einen Streifen mit einer Breite von größer oder gleich 100 Nanometer und kleiner oder gleich 100 Mikrometer aufweist.

## Claims

1. A method for producing an organic radiation-emitting component, comprising the following method steps:
A) providing a first electrode layer (2) on a substrate (1),
B) applying a structured electrically conductive layer (3) on the first electrode layer (2), wherein the electrically conductive layer (3) comprises a metal,
C) producing an electrically insulating layer (4) comprising an oxide of the metal of the electrically conductive layer (3) on the surfaces (31) of the electrically conductive layer (3) which are remote from the first electrode layer (2) by oxidation of the metal,
D) applying at least one organic functional layer (5) on the first electrode layer (2) and the electrically insulating layer (4), and
E) applying a second electrode layer (9) on the at least one organic functional layer (5),
**characterized in that**
- in method step C), the electrically insulating layer (4) is produced with a thickness of greater than or equal to 5 nanometers and less than or equal to 100 nanometers.

2. The method according to claim 1, wherein
- in method step C), oxidation is effected by a method or a combination of methods selected from a group formed by an oxygen plasma treatment, a UV ozone treatment, reactive ion etching and a wet-chemical treatment.

3. The method according to either of the preceding claims,
wherein
- in method step C), the first electrode layer (2) is modified with regard to its wetting property and/or its electrical work function for charge carriers.

4. The method according to any of the preceding claims,
wherein
- in method step B), a base metal is applied as metal of the electrically conductive layer (3), the oxide of said base metal being electrically insulating.

5. The method according to any of the preceding claims,
wherein
- the structured electrically conducting layer comprises Ti or Mg.

6. The method according to any of the preceding claims,
wherein
- in method step B), the electrically conductive layer (3) is applied by sputtering or vaporization.

7. The method according to any of the preceding claims,
wherein
- in method step B), the electrically conductive layer (3) is structured in strip-type fashion.

8. The method according to claim 7, wherein
- at least one strip of the electrically conductive layer (3) extends over a partial region of the first electrode layer (2).

9. An organic radiation-emitting component, comprising
- a first electrode layer (2) on a substrate (1),
- a structured electrically conductive layer (3) comprising a metal on the first electrode layer (2),
- an electrically insulating layer (4) comprising an oxide of the metal of the structured electrically conductive layer, which is arranged on a surface of the electrically conductive layer (3) that is remote from the first electrode layer (2) and which has a thickness of greater than or equal to 5 nanometers and less than or equal to 100 nanometers,
- at least one organic functional layer (5) arranged on the first electrode layer (1) and the electrically insulating layer (4) and
- a second electrode layer (9) arranged on the at least one organic functional layer (5).

10. The component according to claim 9, wherein
- the electrically conductive layer (3) comprises a base metal, the oxide of which is electrically insulating.

11. The component according to claim 9 or 10,
wherein
- the structured electrically conducting layer comprises Ti or Mg.

12. The component according to any of claims 9 to 11,
wherein
- the electrically conductive layer (3) is structured in strip-type fashion.

13. The component according to claim 12, wherein
- the electrically conductive layer (3) has at least one strip having a width of greater than or equal to 100 nanometers and less than or equal to 100 micrometers.

## Revendications

1. Procédé en vue de la fabrication d'un composant organique émetteur de rayonnement, comprenant les étapes de processus de :
A) Préparation d'une première couche d'électrode (2) sur un substrat (1),
B) Application d'une couche structurée électriquement conductrice (3) sur la première couche d'électrode (2), la couche électriquement conductrice (3) présentant un métal,
C) Production d'une couche électriquement isolante (4) par oxydation du métal, comportant un oxyde du métal de la couche électriquement conductrice (3) sur des surfaces (31) détournées de la première couche d'électrode (2) de la couche électriquement conductrice (3),
D) Application d'au moins une unique couche fonctionnelle organique (5) sur la première couche d'électrode (2) et sur la couche électriquement isolante (4) et
E) Application d'une seconde couche d'électrode (9) sur au moins l'unique couche fonctionnelle organique (5),
**caractérisé en ce que**
- à l'étape de procédé C, la couche électriquement isolante (4) est produite avec une épaisseur supérieure ou égale à 5 nanomètres et inférieure ou égale à 100 nanomètres.

2. Procédé selon la revendication 1, selon lequel
- à l'étape de procédé C s'effectue une oxydation par un procédé ou une combinaison de procédés, qui sont sélectionnés à partir d'un groupe, qui est constitué par un traitement par plasma d'oxygène, un traitement à l'ozone et aux UV, une attaque ionique réactive et un traitement par voie chimique humide.

3. Procédé selon une quelconque des revendications précédentes, selon lequel
- à l'étape de procédé C, la première couche d'électrode (2) est modifiée quant à sa propriété de mouillage et/ou son travail de sortie électrique pour les porteurs de charge.

4. Procédé selon une quelconque des revendications précédentes, selon lequel
- à l'étape de procédé B est appliqué comme métal de la couche électriquement conductrice (3) un métal commun, dont l'oxyde est électriquement isolant.

5. Procédé selon une quelconque des revendications précédentes, selon lequel
- la couche structurée électriquement conductrice présente du Ti ou du Mg.

6. Procédé selon une quelconque des revendications précédentes, selon lequel
- à l'étape de procédé B, la couche électriquement conductrice (3) est appliquée par pulvérisation cathodique ou par évaporation.

7. Procédé selon une quelconque des revendications précédentes, selon lequel
- à l'étape de procédé B, la couche électriquement conductrice (3) est structurée en bandes.

8. Procédé selon la revendication 7, selon lequel
- au moins une bande de la couche électriquement conductrice (3) s'étend au-dessus d'un sous-secteur de la première couche d'électrode (2).

9. Composant organique émetteur de rayonnement, comprenant
- une première couche d'électrode (2) sur un substrat (1),
- une couche structurée électriquement conductrice (3) comportant un métal sur la première couche d'électrode (2),
- une couche électriquement isolante (4) comportant un oxyde du métal de la couche structurée électriquement conductrice, qui est disposée sur une surface détournée de la première couche d'électrode (2) de la couche électriquement conductrice (3), et qui présente une épaisseur supérieure ou égale à 5 nanomètres et inférieure ou égale à 100 nanomètres,
- au moins une couche fonctionnelle organique (5), qui est disposée sur la première couche d'électrode (1) et sur la couche électriquement isolante (4), et
- une seconde couche d'électrode (9), qui est disposée sur au moins l'unique couche fonctionnelle organique (5).

10. Composant selon la revendication 9,
- la couche électriquement conductrice (3) présentant un métal commun, dont l'oxyde est électriquement isolant.

11. Composant selon les revendications 9 ou 10,
la couche structurée électriquement conductrice présentant du Ti ou du Mg.

12. Composant selon une quelconque des revendications 9 à 11,
- la couche électriquement conductrice (3) étant structurée en bandes.

13. Composant selon la revendication 12,
- la couche électriquement conductrice (3) présentant au moins une bande d'une largeur supérieure ou égale à 100 nanomètres et inférieure ou égale à 100 micromètres.
